# EUROPÄISCHE PATENTSCHRIFT

(11) **EP 0 868 745 B1**
(45) Veröffentlichungstag und Bekanntmachung des Hinweises auf die Patenterteilung: **10.10.2001**
(21) Anmeldenummer: 96945755.5
(22) Anmeldetag: 28.11.1996
(51) Int. Cl.: H01L 21/8234, H01L 27/105

(54) **VERFAHREN ZUR HERSTELLUNG EINES NEURON-MOS-TRANSISTORS AUF DER BASIS EINES CMOS-PROZESSES**
METHOD OF PRODUCING A NEURON MOS TRANSISTOR ON THE BASIS OF A CMOS PROCESS
PROCEDE DE FABRICATION D'UN NEURISTOR MOS SUR LA BASE D'UN PROCEDE CMOS

(30) Priorität: 22.12.1995 DE 19548529
(43) Veröffentlichungstag der Anmeldung: 07.10.1998
(73) Patentinhaber: Infineon Technologies AG, 81669 München (DE)
(72) Erfinder: WEBER, Werner, D-80637 München (DE); THEWES, Roland, D-82194 Gröbenzell (DE)
(74) Vertreter: Zedlitz, Peter, Dipl.-Inf.
(86) Internationale Anmeldenummer: DE9602286
(87) Internationale Veröffentlichungsnummer: WO9723905

(56) Entgegenhaltungen:
- EP-A- 0 653 793
- WO-A-95/15580
- US-A- 4 953 928

## Beschreibung

In der modernen Datenverarbeitung, insbesondere bei Video und Audioanwendungen, spielen neuronale Netze eine zunehmende Rolle. Die Grundelemente dieser neuronalen Netze sind die Neuronen, bei denen im einfachsten Fall eine Anzahl von Eingängen mit variablem Gewicht auf einen einzigen Ausgang wirken. In einem Neuron werden gewichtete Eingangssignale zu einem Summensignal aufsummiert und das Summensignal anschließend ausgewertet, ob es eine gewisse Schwelle über-bzw. unterschreitet. Heute werden Neuronen zumeist softwaremäßig realisiert. Für schnelle und komplexe Anwendungen neuronaler Netze ist jedoch die hardwaremäßige Implementierung von Neuronen erforderlich.

Aus den IEEE Transactions on Electron Devices, Vol. 39, No. 6, June 1992, Seiten 1444-1455 ist ein Bauelement bekannt, das eine logische Verknüpfung mehrerer Eingänge durch eine Schwellwertbildung ermöglicht. Nachteilig ist hierbei, daß dieses Bauelement keinen "gewöhnlichen" CMOS-Prozeß, sondern einen EPROM-Herstellprozeß mit zwei Polysiliziumschichten erfordert, wobei eine Polysiliziumschicht für ein Floating Gate und eine weitere Polysiliziumschicht für die Gegenelektroden der Einkoppelkapazitäten erforderlich sind.

Die der Erfindung zugrundeliegende Aufgabe besteht nun darin, ein Verfahren zur Herstellung eines solchen Bauelementes anzugeben, das möglichst einem gewöhnlichen CMOS-Herstellprozeß entspricht bzw. bei dem möglichst wenig zusätzliche Prozeßschritte erforderlich sind.

Diese Aufgabe wird erfindungsgemäß durch die im Patentanspruch 1 angegebenen Merkmale gelöst. Die Unteransprüche betreffen vorteilhafte Ausgestaltungen der Erfindung.

Die Erfindung wird nachfolgend anhand der Zeichnungen erläutert. Dabei zeigt
- Figur 1: ein Neuron-MOS-Transistor zur Erläuterung des erfindungs gemäßen Verfahrens,
- Figur 2: einen Schnitt durch das Bauelement von Figur 1 und
- Figur 3: ein weiteres Bauelement zur Erläuterung einer vorteilhaften Weiterbildung des erfindungsgemäßen Verfahrens.

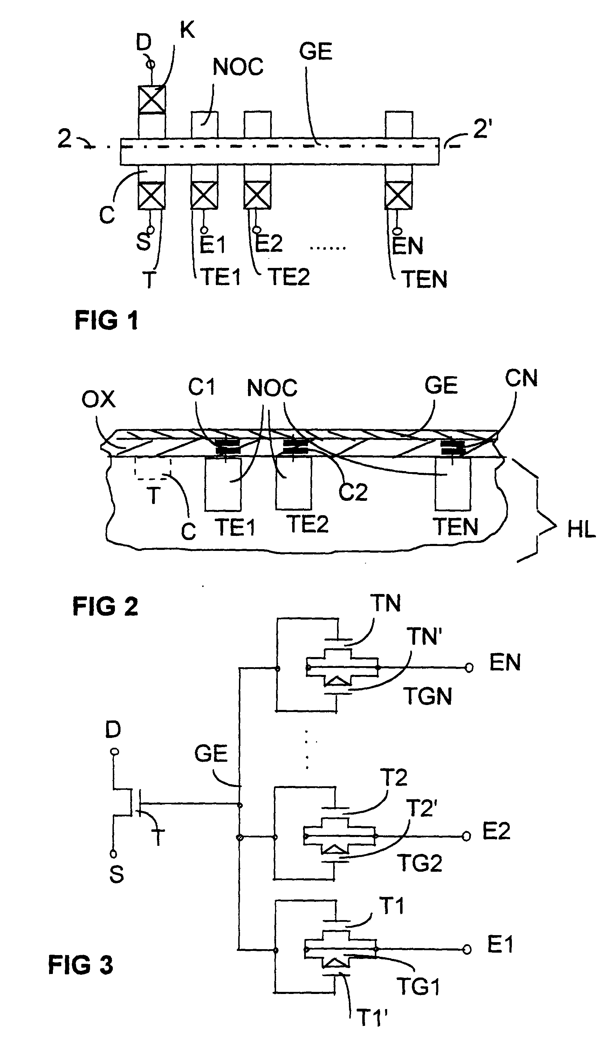

In Figur 1 ist ein Neuron-MOS-Transistor dargestellt, der einen CMOS-Transistor T und eine Mehrzahl von "Transistorkapazitäten" aufweist, die über eine gemeinsame Gateelektrode GE, beispielsweise aus Polysilizium, verfügen. Der Transistor T verfügt über einen Kanalbereich C aus Substratmaterial oder aber auch aus einem schwacher dotierten Gebiet mit einer zum Substrat unterschiedlichen Leitfähigkeitstyp bestehen. Die sogenannten Transistorkapazitäten TE hingegen weisen stark dotierte Kanalgebiete NOC mit dem Leitfähigkeitstyp von Drain- bzw. Sourcegebiet auf, deren Dotierungskonzentration mindestens ein bis zwei Größenordnungen größer ist als die Dotierungskonzentration des Kanals C. Die Transistorkapazitäten TE sind zwar ähnlich wie Transistoren aufgebaut und herstellbar, sind aber eigentlich keine Transistoren, da nur ein Zweipol mit kapazitiver Wirkung vorliegt.

Beim Transistor T ist jeweils ein zum Kanalgebiet C angrenzendes erstes Halbleitergebiet über ein Kontaktloch K mit einem Drainanschluß D und ein zweites an den Kanal C angrenzendes Halbleitergebiet über ein weiteres Kontaktloch mit einem Sourceanschluß S verbunden. Bei den Transistorkapazitäten TE ist jeweils ein zum jeweiligen stark dotierten Kanalgebiet angrenzendes Halbleitergebiet über ein Kontaktloch mit einem jeweiligen Eingang E1 ... EN verbunden. In Figur 1 ist ferner ein Längsschnitt entlang einer Achse 2' angedeutet, der in Figur 2 dargestellt ist.

Der Längsschnitt von Figur 2 zeigt einen Halbleiterkörper HL in den im Bereich des Transistors T ein Kanalgebiet C aus Substratmaterial oder gestrichelt angedeutet ein n-dotiertes Kanalgebiet C und im Bereich der Transistorkapazitäten TE voneinander getrennte n⁺-dotierte Kanalgebiete NOC (Normally-On Channels) eingebracht sind, wobei die Kanalgebiete NOC wesentlich tiefer sind als das Kanalgebiet C. Ferner ist eine durch eine Oxidschicht OX vom Halbleiterkörper HL getrennte Gateelektrode GE dargestellt. Es erfolgt eine kapazitive Einkopplung der Eingänge E1 ... EN von den Kanalgebieten NOC der Transistorkapazitäten TE über Kapazitäten C1 ... CN. Es ist somit keine weitere Polysiliziumschicht für die einzelnen Kapazitätselektroden erforderlich, da diese durch die stark dotierten Gebiete NOC gebildet werden.

Die leitenden Kanäle NOC der Transistorkapazitäten TE werden beispielsweise durch eine zusätzliche Implantation mit einer eigenen Maske oder aber alternativ für eine sowieso vorgesehene n-Implantation, die beispielsweise für eine n-Wannenimplantation erforderlich ist, erzeugt, wobei im letzteren Fall keine eigene Maske nötig ist und die Implantation lediglich in der ohnehin benötigten Implantationsmaske berücksichtigt werden muß.

Eine weitere Möglichkeit die Einkoppelkapazitäten C1 ... CN zu realisieren wird anhand von Figur 3 näher erläutert. Bei der in Figur 3 gezeigten Anordnung ist wiederum ein Transistor T mit Anschlüssen S und D vorgesehen, dessen Gate jeweils über ein Transfergate TG1 ... TGN mit einem jeweiligen Eingang E1 ... EN verbunden, wobei die Transfergates jeweils aus einem n-Kanal-Transistor T1 ... TN und jeweils aus einem p-Kanal-Transistor TE1' bestehen, wobei die Gateelektroden aller Eingangstransistoren T1, T1' ... TN, TN' mit der Gateelektrode des Transistors T verbunden sind und wobei jeweils mindestens einer der beiden weiteren Anschlüsse eines jeweiligen n-Kanal- und eines jeweiligen p-Kanal-Transistors gemeinsam mit einem jeweiligen Eingang E1 ... EN verbunden sind. Die Transistoren T1 ... TN sind "gewöhnliche" Transistoren wie der Transistor T, das heißt sie weisen keine besondere Kanaldotierung auf, wie dies beispielsweise bei der Ausführungsform von Figur 1 der Fall ist.

Vorteilhaft ist hierbei daß diese letztere Weiterbildung des erfindungsgemäßen Verfahrens gänzlich ohne irgendwelche Prozeßmodifikationen gegenüber einem gewöhnlichen CMOS-Prozeß auskommt.

In diesem Fall werden die Floating-Gate-Elektroden durch das Polysilizium der Gates des jeweiligen n-Kanal-Transistors und des jeweiligen p-Kanal-Transistors gebildet, wobei beide mit einem jeweiligen Eingang verbundenen Transistoren vorteilhafterweise jeweils die gleiche Gatefläche haben sollen.

Folgende Betriebsfälle müssen hierbei unterschieden werden, wobei für die Eingänge nur volle logische Pegel, also nur Werte 0 Volt oder V_{DD} zugelassen werden:
1. Mittleres Potential auf dem Floating Gate:
   Diese Bedingung ist wichtig für eine korrekte Bewertung, da die Schaltschwelle in der Gegend mittlerer Potentiale liegt. Liegt ein Eingang auf 0 Volt, so existiert ein leitender Kanal und damit eine hohe Kapazität nur beim n-Kanal-MOSFET, der mit seiner der Transistorfläche entsprechenden Kapazität auf das Floating Gate koppelt. Der p-Kanal-MOSFET ist gesperrt und der Kanal in Verarmung, wodurch damit der Beitrag zur Kopplung vernachlässigbar ist. Liegt am Eingang die Spannung V_{DD} an, so ist umgekehrt der p-MOSFET leitend und koppelt entsprechend auf das Floating Gate, während der n-MOSFET sperrt und kaum zur Kapazität beiträgt.
2. Niedriges Potential von etwa 0 Volt auf dem Floating Gate:
   Bei diesem Wert ist das Floating Gate weit von der Schaltschwelle entfernt. Eine leichte Fehlbewertung auf dem Floating Gate hat damit kaum Auswirkungen auf die Bewertung. Bei Eingangsspannungen von 0 Volt leitet im Grenzfall einer der Transistoren und eine Kopplung auf das Gate unterbleibt. Würde sie stattfinden, würde dies jedoch lediglich zu einer weiteren Absenkung des Pegel am Floating Gate, wobei die Absenkung eine Vergrößerung des Abstandes zur Schaltschwelle bedeutet. Liegen die Eingänge an einem Spannungspegel V_{DD} leitet der p-MOSFET während der n-MOSFET sperrt. Die Kopplung ist in diesem Fall nur durch den p-MOSFET gegeben und somit korrekt.
3. Hohes Potential von ca. V_{DD} auf dem Floating Gate:
   Bei diesem Wert ist das Floating Gate Potential ebenfalls weit von der Schaltschwelle entfernt. Eine leichte potentialänderungen auf dem Floating Gate haben kaum Auswirkungen auf die Bewertung. Für den Fall, daß ein jeweiliger Eingang auf einem Pegel V_{DD} liegt, leitet im Grenzfall keiner der beiden jeweiligen Transistoren und eine Kopplung auf das Gate unterbleibt. Würde sie hingegen stattfinden, so führte dies jedoch lediglich zu einer weiteren Anhebung des Pegels am Floating Gate, wobei die Entfernung zur Schaltschwelle vergrößert würde. Wird ein jeweiliger Eingang mit 0 Volt beschaltet, so leitet der n-MOSFET während der p-MOSFET sperrt. Die Kopplung ist in diesem Fall korrekt, da sie nur durch den n-MOSFET bewirkt wird. Fehlerhafte Einkopplungen können also nur bei Potentialen des Floating Gate auftreten, die in der Nähe von 0 Volt oder V_{DD} liegen, diese Pegel sind jedoch irrelevant für die Bewertung eines Neurons-MOS-Transistor.

## Patentansprüche

1. Verfahren zur Herstellung eines Neuron-MOS-Transistors auf der Basis eines CMOS-Prozesses, bei dem zwischen einer Gateelektrode (GE) eines MOS-Transistors (T) und jeweiligen Eingängen (E1 ... EN) vorgesehenen Koppelkapazitäten (C1 ... CN) dadurch erzeugt werden, daß jeweilige erste Kondensatorplatten durch Kanalgebiete (NOC) von Transistorkapazitäten (T1 ... TN) gebildet werden, wobei jeweilige Kanalgebiete (NOC) der Transistorkapazitäten im Vergleich zum Kanalgebiet (C) des Transistors (T) wesentlich stärker dotiert sind, und
daß die Gateelektrode (GE) des Transistors (T) gleichzeitig für alle Koppelkapazitäten als zweite Kondensatorplatte dient.

2. Verfahren nach Anspruch 1,
bei dem die wesentlich stärkere Dotierung der Kanäle (NOC) der Transistorkapazitäten (T1 ... TEN) durch eine zusätzliche Implantation mit einer eigenen Maske erzeugt wird.

3. Verfahren nach Anspruch 1,
bei dem die wesentlich stärkere Dotierung der Kanalgebiete (NOC) der Transistorkapazitäten (TE1 ... TEN) durch eine ohnehin vorgesehene Wannenimplantation erzielt wird, wobei die zusätzliche Implantation in der Maske für die Wannenimplantation berücksichtigt wird.

4. Verfahren zur Herstellung eines Neuron-MOS-Transistors auf der Basis eines CMOS-Prozesses,
bei dem ein MOS-Transistor (T) und für einen jeweiligen Eingang ein jeweiliges Transfergate (TG1 ... TGN) vorgesehen werden, bei dem eine Gateelektrode des Transistors (T) und alle Gateelektroden der Transistoren (T1 ... TN') der Transfergates mit Hilfe einer gemeinsamen Gateelektrode gebildet werden und bei dem jeweils mindestens ein Anschluß der jeweiligen Transistoren (T1,T1' ... TN,TN') eines jeweiligen Transfergates mit einem jeweiligen Eingang (E1 ... EN) verbunden werden.

5. Verfahren nach Anspruch 4,
bei dem die gemeinsame Gateelektrode (GE) aus Polysilizium erzeugt wird.

## Claims

1. Method of producing a neuron MOS transistor -on the basis of a CMOS process, in which coupling capacitances (C1 ... CAN) provided between a gate electrode (GE) of a MOS transistor (T) and respective inputs (E1 ... EN) are produced by respective first capacitor plates being formed by channel regions (NOC) of transistor capacitances (T1 ... TN), respective channel regions (NOC) of the transistor capacitances being significantly more heavily doped in comparison with the channel region (C) of the transistor (T), and the gate electrode (GE) of the transistor (T) simultaneously serving as second capacitor plate for all the coupling capacitances.

2. Method according to Claim 1,
in which the significantly heavier doping of the channels (NOC) of the transistor capacitances (T1 ... TEN) is produced by an additional implantation using a dedicated mask.

3. Method according to Claim 1,
in which the significantly heavier doping of the channel regions (NOC) of the transistor capacitances (TE1 ... TEN) is achieved by a well implantation that is provided in any case, the additional implantation being taken into account in the mask for the well implantation.

4. Method of producing a neuron MOS transistor on the basis of a CMOS process,
in which a MOS transistor (T) and, for a respective input, a respective transfer gate (TG1 ... TGN) are provided, in which a gate electrode of the transistor (T) and all the gate electrodes of the transistors (T1 ... TN') of the transfer gates are formed with the aid of a common gate electrode, and in which in each case at least one terminal of the respective transistors (T1, T1' ... TN, TN') of a respective transfer gate .is connected to a respective input (E1 ... EN).

5. Method according to Claim 4,
in which the common gate electrode (GE) is produced from polysilicon.

## Revendications

1. Procédé de fabrication d'un transistor MOS neuronal sur la base d'un procédé CMOS, dans lequel des capacités (C1 ... CN) de couplage prévues entre une électrode (GE) de grille d'un transistor (T) MOS et une entrée (E1 ... EN) associée sont produites par le fait que des premières plaques de condensateurs associés sont formées par des régions (NOC) de canal des capacités (T1 ... TN) de transistor, des régions (NOC) de canal associé des capacités de transistor étant dopées sensiblement plus fortement que la région (C) de canal du transistor (T), et par le fait que l'électrode (GE) de grille du transistor (T) sert de deuxième plaque de condensateur en même temps pour toutes les capacités de couplage.

2. Procédé suivant la revendication 1, dans lequel le dopage sensiblement plus fort des canaux (NOC) des capacités (T1 ... TEN) de transistor est produit par une implantation supplémentaire avec un masque propre.

3. Procédé suivant la revendication 1, dans lequel le dopage sensiblement plus fort des régions (NOC) de canal des capacités (TE1 ... TEN) de transistor est obtenue par une implantation de cuvette prévue de toute façon, l'implantation supplémentaire étant prise en compte dans le masque pour l'implantation de cuvette.

4. Procédé de fabrication d'un transistor MOS neuronal sur la base d'un procédé CMOS, dans lequel il est prévu un transistor (T) MOS et, pour une entrée associée, une grille (TG1 ... TGN) de transfert associé, dans lequel une électrode de grille du transistor (T) et toutes les électrodes de grille des transistors (T1 ...TN') des grilles de transfert sont formées à l'aide d'une électrode de grille commune et dans lequel respectivement au moins une borne des transistors (T1, T1' ... TN, TN') associée d'une grille de transfert associé est reliée à une entrée (E1 ...EN) associée.

5. Procédé suivant la revendication 4, dans lequel l'électrode (GE) de grille commune est produite en polysilicium.
